# EUROPÄISCHE PATENTANMELDUNG

(11) **EP 1 394 558 A1**
(43) Veröffentlichungstag der Anmeldung: **03.03.2004**
(21) Anmeldenummer: 02360243.6
(22) Anmeldetag: 26.08.2002
(51) Int. Cl.: G01R 31/3167, G01R 35/00, H03M 1/10

(54) **Vorrichtung zur sicherheitstechnischen Prüfung eines Analog/Digital-Umsetzers**

(71) Anmelder: ALCATEL, 75008 Paris (FR)
(72) Erfinder: Klose, Bernd, 71679 Asperg (DE)
(74) Vertreter: Menzietti, Domenico, Dipl.-Ing

(57) **Zusammenfassung**

Die erfindungsgemäße Vorrichtung zur sicherheitstechnischen Prüfung eines Analog/Digital-Umsetzers während des Betriebs prüft mindestens zwei unterschiedliche Referenzspannungen.

Sie beinhaltet eine Recheneinheit (µC1), einen Analog-Digital-Umsetzer (A/D1) und einen Multiplexer (MUX1), letzterer mit mindestens drei Eingängen und einem Ausgang, wobei ein erster Eingang mit einer vorbestimmten, ersten Referenzspannung belegt ist und ein zweiter Eingang mit einer vorbestimmten, zweiten Referenzspannung belegt ist, wobei der Ausgang mit dem zu prüfenden Analog/Digital-Umsetzer (A/D1) verbunden ist.

Die Recheneinheit (µC1) ist derart eingerichtet, den Multiplexer (MUX1) so zu steuern, dass die Referenzspannungen zeitweise dem Analog/Digital-Umsetzer (A/D1) zugeführt werden, und die entsprechenden Ausgangssignale des Analog/Digital-Umsetzers (A/D1) zu empfangen und mit einem oder zwei Sollwerten zu vergleichen.

## Beschreibung

Die Erfindung betrifft Vorrichtung zur sicherheitstechnischen Prüfung eines Analog/Digital-Umsetzers.

Vornehmlich in der Eisenbahnsignaltechnik werden Vorrichtungen und Anordnungen aus Sicherheitsaspekten besonders sicher ausgestaltet. Dazu gehört z.B. einzelne Module doppelt oder gar dreifach vorzusehen und eine Verarbeitung nur dann als sicher anzusehen, wenn im Fall von zwei Modulen beide dasselbe Ergebnis liefern und in Falle von drei Modulen zumindest zwei Module dasselbe Ergebnis liefern.

Vor dem Einsatz eines Moduls wird es einer Funktionsprüfung unterzogen. Dies gilt auch für Analog/Digital-Umsetzer, die in der Eisenbahnsignaltechnik zum Einsatz kommen. Mittels der Analog/Digital-Umsetzer werden z.B. Spannungen oder Ströme in Lampenfäden oder im Weichenmotor gemessen.

Üblicherweise werden in einer Anordnung zwei Analog/Digital-Umsetzer verwendet und dazu zwei Multiplexer, zwei Recheneinheiten sowie zwei Referenzspannungsquellen. Jede Recheneinheit ist z.B. als entsprechend programmierter Mikrokontroller oder -prozessor ausgeführt.

Jede Referenzspannungsquelle dient zur Generierung einer Referenzspannung, die zum einen dem einen Analog/Digital-Umsetzer einen Referenzwert für eine maximale Eingangspannung vorgibt und zum anderen dem anderen Analog/Digital-Umsetzer über den zugehörigen Multiplexer zugeführt wird, um als Messwert am Ausgang des Analog/Digital-Umsetzers zur Verfügung zu stehen. Mittels des Messwertes wird überprüft, ob der maximale Eingangswert in einen entsprechenden Sollausgangwert umgesetzt wird und folglich der Analog/Digital-Umsetzer zumindest für diesen Wert funktionsfähig ist.

Die Prüfung des Analog/Digital-Umsetzers ist insofern unzureichend als beispielsweise Kurzschlüsse im Analog/Digital-Umsetzer, die zu einem steten Maximalwert am Ausgang des Analog/Digital-Umsetzers führen, nicht erkannt werden können.

Aufgabe der Erfindung ist es, die Funktionsprüfung eines Analog/Digital-Umsetzers während des Betriebs zu verbessern.

Gelöst wird diese Aufgabe durch eine Vorrichtung nach Anspruch 1.

Die erfindungsgemäße Vorrichtung zur sicherheitstechnischen Prüfung eines Analog/Digital-Umsetzers während des Betriebs prüft mindestens zwei unterschiedliche Referenzspannungen.

Sie beinhaltet eine Recheneinheit, einen Analog-Digital-Umsetzer und einen Multiplexer, letzterer mit mindestens drei Eingängen und einem Ausgang, wobei ein erster Eingang mit einer vorbestimmten, ersten Referenzspannung belegt ist und ein zweiter Eingang mit einer vorbestimmten, zweiten Referenzspannung belegt ist, wobei der Ausgang mit dem zu prüfenden Analog/Digital-Umsetzer verbunden ist.

Die Recheneinheit ist derart eingerichtet, den Multiplexer so zu steuern, dass die Referenzspannungen zeitweise dem Analog/Digital-Umsetzer zugeführt werden, und die entsprechenden Ausgangssignale des Analog/Digital-Umsetzers zu empfangen und mit einem oder zwei Sollwerten zu vergleichen.

Bei einer vorteilhaften Ausgestaltung der Vorrichtung unterscheiden sich die erste und die zweite Referenzspannung im Wert voneinander.

Bei einer weiteren vorteilhaften Ausgestaltung der Vorrichtung ist ein dritter Eingang mit einer vorbestimmten, dritten Referenzspannung belegt.

Bei einer weiteren vorteilhaften Ausgestaltung der Vorrichtung ist ein vierter Eingang mit einer vorbestimmten, vierten Referenzspannung und ein fünfter Eingang mit einer vorbestimmten, fünften Referenzspannung belegt.

Vorteilhafterweise ist eine Referenzspannungsquelle vorgesehen ist, die mit einer Reihenschaltung aus mindestens zwei ohmschen Widerständen verbunden ist. Die erste und die zweite Referenzspannung sind an unterschiedlichen Stellen der Reihenschaltung abgegriffen.

Die erfindungsgemäße Vorrichtung ist in einer weiteren Ausgestaltung derart ausgestaltet, dass ein dritter Eingang mit einer vorbestimmten, dritten Referenzspannung, ein vierter Eingang mit einer vorbestimmten, vierten Referenzspannung und ein fünfter Eingang mit einer vorbestimmten, fünften Referenzspannung belegt ist. Eine Referenzspannungsquelle ist vorgesehen, die mit einer Reihenschaltung aus drei ohmschen Widerständen verbunden ist. Die erste, die zweite, die dritte und die vierte Referenzspannung sind an unterschiedlichen Stellen der Reihenschaltung abgegriffen und unterscheiden sich im Wert voneinander. Die fünfte Referenzspannung entspricht in ihrem Wert der ersten Referenzspannung.

Die erfindungsgemäße Anordnung zur Messung von Strom- oder Spannungswerten beinhaltet eine erste Referenzspannungsquelle, einen ersten Multiplexer, einen ersten Analog/Digital-Umsetzer und eine erste Recheneinheit sowie eine zweite Referenzspannungsquelle, einen zweiten Multiplexer, einen zweiten Analog/Digital-Umsetzer und eine zweite Recheneinheit. Der erste und der zweite Multiplexer weisen jeweils mindestens drei Eingänge und einen Ausgang auf. Ein erster Eingang des ersten Multiplexers ist mit einer vorbestimmten, ersten, mittels der ersten Referenzspannungsquelle generierten Referenzspannung belegt. Ein zweiter Eingang des ersten Multiplexers ist mit einer vorbestimmten, ersten, mittels der zweiten Referenzspannungsquelle generierten Referenzspannung belegt. Ein erster Eingang des zweiten Multiplexers ist mit einer vorbestimmten, dritten, mittels der zweiten Referenzspannungsquelle generierten Referenzspannung belegt und ein zweiter Eingang des zweiten Multiplexers ist mit einer vorbestimmten, vierten, mittels der ersten Referenzspannungsquelle generierten Referenzspannung belegt. Die erste Recheneinheit ist derart eingerichtet, den ersten Multiplexer so zu steuern, dass die am ersten Multiplexer anliegenden Referenzspannungen zeitweise dem ersten Analog/Digital-Umsetzer zugeführt werden, und die entsprechenden Ausgangssignale des ersten Analog/Digital-Umsetzers zu empfangen und mit Sollwerten zu vergleichen. Die zweite Recheneinheit ist derart eingerichtet, den zweiten Multiplexer so zu steuern, dass die am zweiten Multiplexer anliegenden Referenzspannungen zeitweise dem zweiten Analog/Digital-Umsetzer zugeführt werden, und die entsprechenden Ausgangssignale des zweiten Analog/Digital-Umsetzers zu empfangen und mit Sollwerten zu vergleichen.

Bei der Anordnung entspricht die vierte Referenzspannung in ihrem Wert vorteilhafterweise der ersten Referenzspannung und die dritte Referenzspannung in ihrem Wert der zweiten Referenzspannung.

Bei einer vorteilhaften Ausgestaltung der Anordnung ist der Ausgang der ersten Referenzspannungsquelle mit einer ersten Reihenschaltung aus mindestens zwei ohmschen Widerständen verbunden und über einen weiteren ohmschen Widerstand mit dem zweiten Eingang des zweiten Multiplexers. Ferner ist der Ausgang der zweiten Referenzspannungsquelle mit einer zweiten Reihenschaltung aus mindestens zwei ohmschen Widerständen verbunden und über einen weiteren ohmschen Widerstand dem mit zweiten Eingang des ersten Multiplexers.

Bei einer weiteren vorteilhaften Ausgestaltung der Anordnung ist der Ausgang der ersten Referenzspannungsquelle mit einer ersten Reihenschaltung aus drei ohmschen Widerständen verbunden. Die erste und mindestens eine weitere, einem weiteren Eingang des ersten Multiplexers zugeführte Referenzspannung sind an unterschiedlichen Stellen der ersten Reihenschaltung abgegriffen. Sie unterscheiden sich im Wert voneinander. Der Ausgang der zweiten Referenzspannungsquelle ist mit einer zweiten Reihenschaltung aus drei ohmschen Widerständen verbunden. Die dritte und mindestens eine weitere, einem weiteren Eingang des zweiten Multiplexers zugeführte Referenzspannung sind an unterschiedlichen Stellen der zweiten Reihenschaltung abgegriffen und unterscheiden sich im Wert voneinander.

Das erfindungsgemäße Verfahren zur sicherheitstechnischen Prüfung eines Analog/Digital-Umsetzers während des Betriebs weist folgende Schritte auf:
- Durchschalten einer an einem ersten Eingang eines Multiplexers anliegenden ersten Referenzspannung zum Eingang des zu überprüfenden Analog/Digital-Umsetzers,
- Messen des Ausgangssignals des Analog/Digital-Umsetzers,
- Vergleichen des gemessenen Ausgangssignals mit einem ersten Sollwert,
- Durchschalten einer an einem zweiten Eingang eines Multiplexers anliegenden zweiten Referenzspannung zum Eingang des zu überprüfenden Analog/Digital-Umsetzers,
- Messen des Ausgangssignals des Analog/Digital-Umsetzers,
- Vergleichen des gemessenen Ausgangssignals mit dem ersten oder einem zweiten Sollwert.

Im folgenden werden drei Ausführungsbeispiele der Erfindung unter Zuhilfenahme von drei Figuren erläutert. Es zeigen:
- Fig. 1: eine schematische Darstellung einer ersten erfindungsgemäßen Vorrichtung zur sicherheitstechnischen Prüfung eines Analog/Digital-Umsetzers während des Betriebs,
- Fig. 2: eine schematische Darstellung einer zweiten erfindungsgemäßen Vorrichtung zur sicherheitstechnischen Prüfung eines Analog/Digital-Umsetzers während des Betriebs und
- Fig. 3: eine schematische Darstellung einer erfindungsgemäßen Anordnung zur sicherheitstechnischen Prüfung von zwei Analog/Digital-Umsetzern während des Betriebs.

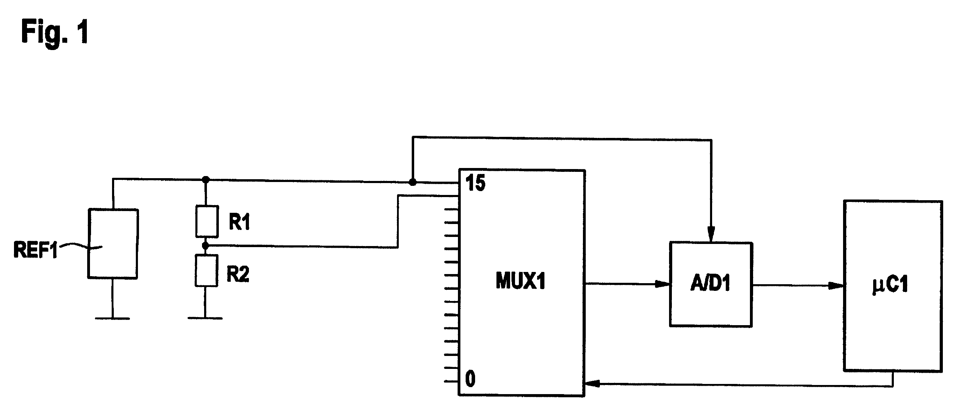

Das erste Ausführungsbeispiel wird nun unter Zuhilfenahme von Fig. 1 erläutert. Fig. 1 zeigt eine erste erfindungsgemäße Vorrichtung. Die Vorrichtung beinhaltet eine Referenzspannungsquelle REF1, eine Reihenschaltung aus zwei ohmschen Widerständen R1 und R2, einen Multiplexer MUX1, einen Analog/Digital-Umsetzer A/D1 und eine Recheneinheit µC1.

Der Multiplexer MUX1 ist z.B. ein Zeitmultiplexer mit 16 Eingängen 0-15, einem Steuereingang und einem Ausgang. Er wird durch eine nicht dargestellte Stromversorgung, die ebenfalls der Analog/Digital-Umsetzer A/D1 und die Recheneinheit µC1 versorgt, mit der nötigen Betriebsleistung versorgt. Der Ausgang ist mit dem analogen Eingang des Analog/Digital-Umsetzers A/D1 verbunden. Gesteuert wird der Multiplexer MUX1 über die Recheneinheit µC1. Der Multiplexer MUX1 dient dazu, verschiedene Eingänge zwecks Messung verschiedener Ströme oder Spannungen bereitzustellen. Die Ströme sind z.B. Ströme von Lampenfäden, die Spannungen z.B. Spannungen von Weichenmotoren.

Die Recheneinheit µC1 ist z.B. als Mikrokontroller oder als Mikroprozessor ausgebildet. Der digitale Ausgang des Analog/Digital-Umsetzers A/D1 ist mit einem Eingang der Recheneinheit µC1 verbunden.

Die Referenzspannungsquelle REF1 liefert eine Referenzspannung. Diese wird der Reihenschaltung, dem Eingang 15 des Multiplexers sowie dem Analog/Digital-Umsetzer A/D1 zugeführt. Eingang 15 ist damit dauerhaft mit der Referenzspannung belegt und kann nicht mehr zur Messung von Strömen oder Spannungen verwendet werden. Die Wahl des belegten Eingangs ist beliebig, so kann anstelle von Eingang 15 z.B. auch Eingang 12, 11 oder 3 ausgewählt werden. Im Analog/Digital-Umsetzer A/D1 dient die Referenzspannung dazu den Maximalwert anzuzeigen, der dem Bitmuster 1111 entspricht. Gesteuert durch die Recheneinheit µC1 ist es somit möglich, den Eingang 15 zeitweise an den Analog/Digital-Umsetzer A/D1 durchzuschalten, um dem Analog/Digital-Umsetzer A/D1 die Referenzspannung zuzuführen. Arbeitet der Analog/Digital-Umsetzer A/D1 fehlerfrei generiert er am Ausgang das Bitmuster 1111. Dieses wird der Recheneinheit µC1, die einen Vergleich mit dem Sollwert 1111 vornimmt und im fehlerfreien Fall eine Übereinstimmung feststellt. Im fehlerbehafteten Fall stellt die Recheneinheit µC1 keine Überseinstimmung fest, was zu einer Fehlermeldung führt. Die korrekte Arbeitsweise des Analog/Digital-Umsetzers A/D1 ist somit während des Betriebs und mittels des Bitmusters 1111 überprüfbar.

Zwischen den ohmschen Widerständen R1 und R2 liegt eine weitere Referenzspannung an. Der Wert dieser weiteren Referenzspannung hängt von der Wahl der Widerstände ab. Wird R1 beispielsweise doppelt so groß wie R2 gewählt, so liegt zwischen den Widerständen ein Drittel der Referenzspannung an, die dem Bitmuster 0101 entspricht. Wird R2 beispielsweise doppelt so groß wie R1 gewählt, so liegt zwischen den Widerständen zwei Drittel der Referenzspannung an, die dem Bitmuster 1010 entspricht. Werden R1 und R2 gleich groß gewählt, so liegt zwischen den Widerständen die halbe Referenzspannung an, die dem Bitmuster 1000 entspricht.

Die weitere Referenzspannung wird beispielsweise Eingang 14 des Multiplexers MUX1 zugeführt. Durch zeitweises Weiterleiten der weiteren Referenzspannung zum Analog/Digital-Umsetzer A/D1 und Vergleichen des digitalen Ausgangssignals des Analog/Digital-Umsetzers A/D1 mit dem vorgegebenen Sollwert wird Funktionsfähigkeit des Analog/Digital-Umsetzers A/D1 während des Betriebs überprüft.

Die Referenzspannungsquelle REF1 ist vorteilhafterweise mit der Stromversorgung verbunden. Auf diese Weise ist der Aufbau der Referenzspannungsquelle REF1 vereinfacht.

Die Recheneinheit µC1 ist derart programmiert, dass ihr die Eingänge, an denen die unterschiedlichen Referenzspannungen anliegen, und die Werte der Referenzspannungen bekannt sind sowie entsprechende Sollwerte. Durch entsprechendes Ansteuern des Multiplexers MUX1, z.B. mittels eines 4-Bit Datenwortes, werden die Referenzspannungen zeitweise zum Analog/Digital-Umsetzer A/D1 weitergeleitet, die entsprechenden Ausgangssignale des Analog/Digital-Umsetzers A/D1 werden ausgelesen und mit den entsprechenden Sollwerten verglichen. Stellt die Recheneinheit µC1 Übereinstimmung zwischen gemessenen Wert und Sollwert fest, arbeitet der Analog/Digital-Umsetzer A/D1 fehlerfrei, andernfalls fehlerbehaftet. Im fehlerbehafteten Fall wird von der Recheneinheit µC1 eine Fehlermeldung zum elektronischen Stellwerk übermittelt oder eine akustische und/optische Warnmeldung ausgegeben. Ein Monteur wird informiert und zum Austausch des fehlerbehafteten Analog/Digital-Umsetzer A/D1 angewiesen.

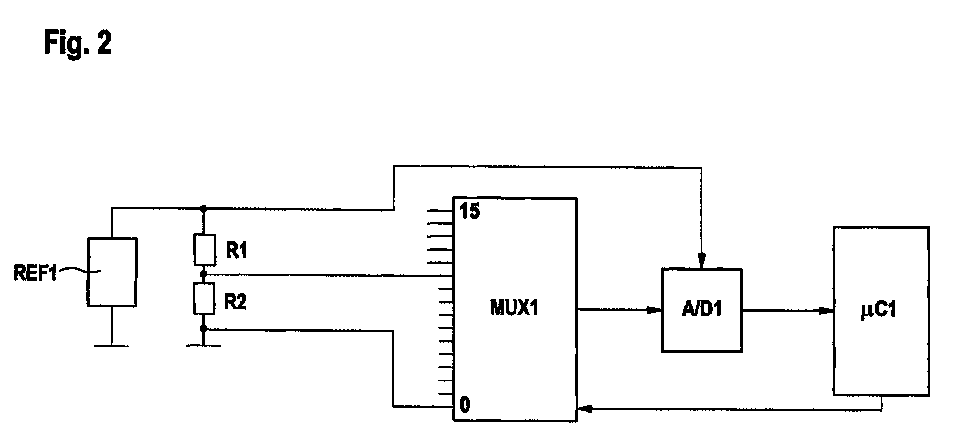

Das zweite Ausführungsbeispiel wird nun unter Zuhilfenahme von Fig. 2 erläutert. Fig. 2 zeigt eine zweite erfindungsgemäße Vorrichtung, die im wesentlichen der ersten Vorrichtung aus dem ersten Ausführungsbeispiel entspricht. Im Unterschied zur ersten Vorrichtung wird bei der zweiten Vorrichtung die Referenzspannung zwischen den ohmschen Widerständen R1 und R2 Eingang 10 des Multiplexers MUX1 zugeführt sowie als weitere Referenzspannung Masse verwendet, die dem Eingang 0 des Multiplexers MUX1 zugeführt ist.

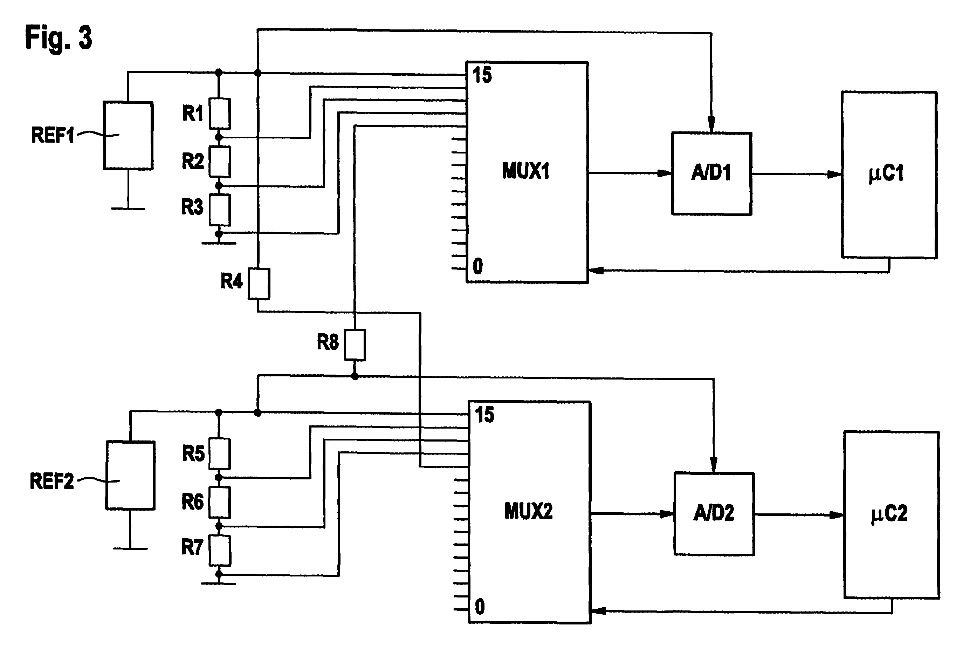

Das dritte Ausführungsbeispiel wird nun unter Zuhilfenahme von Fig. 3 erläutert. Fig. 3 zeigt eine erfindungsgemäße Anordnung zur sicherheitstechnischen Prüfung von zwei Analog/Digital-Umsetzern während des Betriebs. Die Anordnung ist aus zwei Vorrichtungen aufgebaut, die miteinander verschaltet sind. Die eine Vorrichtung beinhaltet Referenzspannungsquelle REF1, Multiplexer MUX1, Analog/Digital-Umsetzer A/D1, Recheneinheit µC1 und ohmsche Widerstände R1, R2, R3, die in Reihenschaltung verschaltet sind und als Spannungsteiler dienen. Die andere Vorrichtung beinhaltet Referenzspannungsquelle REF2, Multiplexer MUX2, Analog/Digital-Umsetzer A/D2, Recheneinheit µC2 und ohmsche Widerstände R5, R6, R7, die in Reihenschaltung verschaltet sind und als Spannungsteiler dienen.

Jede Vorrichtung entspricht im wesentlichen der ersten Vorrichtung aus Fig. 1 mit dem Unterschied, dass die jeweilige Reihenschaltung drei ohmschen Widerstände aufweist. Aus diese Art und Weise werden für beide Vorrichtungen fünf Referenzspannungen zur Verfügung gestellt: zunächst die Referenzspannung der zugehörigen Referenzspannungsquelle, eine weitere Referenzspannung zwischen Widerständen R1 und R2 bzw. R5 und R6, eine weitere Referenzspannung zwischen Widerständen R2 und R3 bzw. R6 und R7, Masse sowie über einen weiteren Widerstand R8 bzw. R4 die Referenzspannung der Referenzspannungsquelle der jeweils anderen Vorrichtung.

Fünf der 16 Eingänge des Multiplexers MUX1 sind somit dauerhaft mit Referenzspannungen belegt, die restlichen elf Eingänge werden zur Messung von Strömen und/oder Spannungen verwendet. Die Funktionsweise des Analog/Digital-Umsetzers A/D1 wird während des Betriebs mittels der fünf Referenzspannungen überprüft. Es findet eine Überprüfung mittels der Bitmuster 0000, 0101, 1010 und 1111 statt. Das Bitmuster 0000 entspricht dabei Masse, das Bitmuster 0101 einem Drittel der zugehörigen Referenzspannung, Bitmuster 1010 zwei Drittel der zugehörigen Referenzspannung und Bitmuster 1111 der zugehörigen Referenzspannung. Diese Bitmuster ergeben sich durch Wahl von gleichen Widerstandswerten für R1, R2 und R3. Bitmuster 1111 wird zudem bereitgestellt durch die Referenzspannung der anderen Vorrichtung. Damit wird die Prüftiefe für den Analog/Digital-Umsetzers A/D1 erhöht. Es wird nicht nur der Maximalwert überprüft, sondern zwei Zwischenwerte und der Minimalwert. Auf die Weise können auch Kurzschlüsse detektiert werden. Bei einer Toleranz der Widerstände von 0,1 % lassen sich auf diese Weise mindestens 8 Bit des Analog/Digital-Umsetzers prüfen. Die Prüfung ist repräsentativ für das gesamte Wandelspektrum des Analog/Digital-Umsetzers A/D1. Der Analog/Digital-Umsetzer A/D1 wird somit regelmäßig und während des Betriebs einer repräsentativen Funktionsprüfung unterzogen, wodurch ein sicherheitstechnisch prüfbarer Analog/Digital-Umsetzer geschaffen ist.

Entsprechendes gilt für den Analog/Digital-Umsetzer A/D2. Die an der Reihenschaltung abgegriffenen Referenzspannungen werden z.B. den Eingängen 11-15 des Multiplexers zugeführt. Alternativ können sie auch z.B. den Eingängen 15 (Bitmuster 1111), 10 (Bitmuster 1010), 5 Bitmuster (0101), 1 (Bitmuster 1111 der Referenzspannungsquelle REF1), 0 (Bitmuster 0000) zugeführt werden.

## Patentansprüche

1. Vorrichtung zur sicherheitstechnischen Prüfung eines Analog/Digital-Umsetzers (A/D1) während des Betriebs beinhaltend eine Recheneinheit (µC1), einen Analog-Digital-Umsetzer (A/D1) und einen Multiplexer (MUX1), letzterer mit mindestens drei Eingängen und einem Ausgang, wobei ein erster Eingang mit einer vorbestimmten, ersten Referenzspannung belegt ist und ein zweiter Eingang mit einer vorbestimmten, zweiten Referenzspannung belegt ist, wobei der Ausgang mit dem zu prüfenden Analog/Digital-Umsetzer (A/D1) verbunden ist, und wobei die Recheneinheit (µC1) derart eingerichtet ist, den Multiplexer (MUX1) so zu steuern, dass die Referenzspannungen zeitweise dem Analog/Digital-Umsetzer (A/D1) zugeführt werden, und die entsprechenden Ausgangssignale des Analog/Digital-Umsetzers (A/D1) zu empfangen und mit einem oder zwei Sollwerten zu vergleichen.

2. Vorrichtung nach Anspruch 1, **dadurch gekennzeichnet, dass** sich die erste und die zweite Referenzspannung im Wert voneinander unterscheiden.

3. Vorrichtung nach Anspruch 1, **dadurch gekennzeichnet, dass** ein dritter Eingang mit einer vorbestimmten, dritten Referenzspannung belegt ist.

4. Vorrichtung nach Anspruch 1, **dadurch gekennzeichnet, dass** eine Referenzspannungsquelle (REF1) vorgesehen ist, die mit einer Reihenschaltung aus mindestens zwei ohmschen Widerständen (R1, R2) verbunden ist, und dass die erste und die zweite Referenzspannung an unterschiedlichen Stellen der Reihenschaltung abgegriffen sind.

5. Vorrichtung nach Anspruch 1, **dadurch gekennzeichnet, dass** ein dritter Eingang mit einer vorbestimmten, dritten Referenzspannung, ein vierter Eingang mit einer vorbestimmten, vierten Referenzspannung und ein fünfter Eingang mit einer vorbestimmten, fünften Referenzspannung belegt ist, dass eine Referenzspannungsquelle (REF1) vorgesehen ist, die mit einer Reihenschaltung aus drei ohmschen Widerständen (R1, R2, R3) verbunden ist, dass die erste, die zweite, die dritte und die vierte Referenzspannung an unterschiedlichen Stellen der Reihenschaltung abgegriffen sind und sich im Wert voneinander unterscheiden, und dass die fünfte Referenzspannung in ihrem Wert der ersten Referenzspannung entspricht.

6. Anordnung zur Messung von Strom- oder Spannungswerten beinhaltend eine erste Referenzspannungsquelle (REF1), einen ersten Multiplexer (MUX1), einen ersten Analog/Digital-Umsetzer (A/D1) und eine erste Recheneinheit (µC1) sowie eine zweite Referenzspannungsquelle (REF2), einen zweiten Multiplexer(MUX2), einen zweiten Analog/Digital-Umsetzer (A/D2) und eine zweite Recheneinheit (µC2), wobei der erste und der zweite Multiplexer (MUX1, MUX2) jeweils mindestens drei Eingänge und einen Ausgang aufweisen, wobei ein erster Eingang des ersten Multiplexers (MUX1) mit einer vorbestimmten, ersten, mittels der ersten Referenzspannungsquelle (REF1) generierten Referenzspannung belegt ist und ein zweiter Eingang des ersten Multiplexers (MUX1) mit einer vorbestimmten, ersten, mittels der zweiten Referenzspannungsquelle (REF2) generierten Referenzspannung belegt ist, wobei ein erster Eingang des zweiten Multiplexers (MUX2) mit einer vorbestimmten, dritten, mittels der zweiten Referenzspannungsquelle (REF2) generierten Referenzspannung belegt ist und ein zweiter Eingang des zweiten Multiplexers (MUX2) mit einer vorbestimmten, vierten, mittels der ersten Referenzspannungsquelle (REF1) generierten Referenzspannung belegt ist, wobei die erste Recheneinheit (µC1) derart eingerichtet ist, den ersten Multiplexer (MUX1) so zu steuern, dass die am ersten Multiplexer (MUX1) anliegenden Referenzspannungen zeitweise dem ersten Analog/Digital-Umsetzer (A/D1) zugeführt werden, und die entsprechenden Ausgangssignale des ersten Analog/Digital-Umsetzers (A/D1) zu empfangen und mit Sollwerten zu vergleichen, und wobei die zweite Recheneinheit (µC1) derart eingerichtet ist, den zweiten Multiplexer (MUX2) so zu steuern, dass die am zweiten Multiplexer (MUX2) anliegenden Referenzspannungen zeitweise dem zweiten Analog/Digital-Umsetzer (A/D2) zugeführt werden, und die entsprechenden Ausgangssignale des zweiten Analog/Digital-Umsetzers (A/D2) zu empfangen und mit Sollwerten zu vergleichen.

7. Anordnung nach Anspruch 6, **dadurch gekennzeichnet, dass** die vierte Referenzspannung in ihrem Wert der ersten Referenzspannung entspricht, und dass die dritte Referenzspannung in ihrem Wert der zweiten Referenzspannung entspricht.

8. Anordnung nach Anspruch 6, **dadurch gekennzeichnet, dass** der Ausgang der ersten Referenzspannungsquelle (REF1) mit einer ersten Reihenschaltung aus mindestens zwei ohmschen Widerständen (R1, R2) verbunden ist und über einen weiteren ohmschen Widerstand (R4) mit dem zweiten Eingang des zweiten Multiplexers (MUX2) verbunden ist, dass der Ausgang der zweiten Referenzspannungsquelle (REF2) mit einer zweiten Reihenschaltung aus mindestens zwei ohmschen Widerständen (R5, R6) verbunden ist und über einen weiteren ohmschen Widerstand (R8) dem mit zweiten Eingang des ersten Multiplexers (MUX2) verbunden ist.

9. Anordnung nach Anspruch 6, **dadurch gekennzeichnet, dass** der Ausgang der ersten Referenzspannungsquelle (REF1) mit einer ersten Reihenschaltung aus drei ohmschen Widerständen (R1, R2, R3) verbunden ist und die erste und mindestens eine weitere, einem weiteren Eingang des ersten Multiplexers (MUX1) zugeführte Referenzspannung an unterschiedlichen Stellen der ersten Reihenschaltung abgegriffen sind und sich im Wert voneinander unterscheiden, dass der Ausgang der zweiten Referenzspannungsquelle (REF2) mit einer zweiten Reihenschaltung aus drei ohmschen Widerständen (R5, R6, R7) verbunden ist und die dritte und mindestens eine weitere, einem weiteren Eingang des zweiten Multiplexers (MUX2) zugeführte Referenzspannung an unterschiedlichen Stellen der zweiten Reihenschaltung abgegriffen sind und sich im Wert voneinander unterscheiden.

10. Verfahren zur sicherheitstechnischen Prüfung eines Analog/Digital-Umsetzers (A/D1) während des Betriebs mit folgenden Schritten:
- Durchschalten einer an einem ersten Eingang eines Multiplexers (MUX1) anliegenden ersten Referenzspannung zum Eingang des zu überprüfenden Analog/Digital-Umsetzers (A/D1),
- Messen des Ausgangssignals des Analog/Digital-Umsetzers (A/D1),
- Vergleichen des gemessenen Ausgangssignals mit einem ersten Sollwert,
- Durchschalten einer an einem zweiten Eingang eines Multiplexers anliegenden zweiten Referenzspannung zum Eingang des zu überprüfenden Analog/Digital-Umsetzers (A/D1),
- Messen des Ausgangssignals des Analog/Digital-Umsetzers (A/D1),
- Vergleichen des gemessenen Ausgangssignals mit dem ersten oder einem zweiten Sollwert.
